Europäisches Patentamt

European Patent Office

Office européen des brevets

(11) Numéro de publication: **0 631 240 A1**

## DEMANDE DE BREVET EUROPEEN

(21) Numéro de dépôt: **94109474.0**

(22) Date de dépôt: **20.06.94**

(51) Int. Cl.5: **G06F 13/40**, H03M 5/20

(30) Priorité: **22.06.93 FR 9307673**

(43) Date de publication de la demande:
**28.12.94 Bulletin 94/52**

(84) Etats contractants désignés:
**AT BE CH DE DK ES FR GB GR IE IT LI LU MC NL PT SE**

(71) Demandeur: **CSEM, Centre Suisse d'Electronique et de Microtechnique S.A. Recherche et Développement,
Rue de la Maladière 71
CH-2007 Neuchâtel (CH)**

(72) Inventeur: **Chevroulet, Michel
Avenue du Mail 34
CH-2000 Neuchâtel (CH)**

(74) Mandataire: **Patry, Didier Marcel Pierre et al
I C B,
Ingénieurs Conseils en Brevets S.A.,
Passage Max Meuron 6
CH-2001 Neuchâtel (CH)**

(54) **Circuit de transmission de données.**

(57) L'invention comprend un circuit de transmission de données ayant un dispositif asservi (3), un dispositif maître (2) et un bus à deux fils (6) pour transmettre des informations numériques entre ceux-ci.

Le dispositif maître (2) produit une différence de potentiel (V(t)) entre lesdits deux fils de manière à fournir de l'énergie audit dispositif asservi (3) et comprend des moyens (41) pour produire des impulsions dans ladite différence de potentiel (V(t)) lesdites impulsions ayant une amplitude représentative desdites informations numériques. Le dispositif asservi (3) comprend des moyens (20) de décodage des impulsions pour détecter lesdites impulsions et pour produire un signal de synchronisation (Clk) lors de la détection de chacune desdites impulsions.

Ainsi, le dispositif maître peut transmettre des informations, de l'énergie et les signaux de synchronisation au dispositif asservi sur deux lignes uniquement, sans nécessiter une horloge locale dans le dispositif asservi.

Fig.1

EP 0 631 240 A1

La présente invention concerne de manière générale les circuits de transmission de données qui comprennent au moins un dispositif asservi, un dispositif maître pour commander le fonctionnement du dispositif asservi, et un bus bifilaire pouvant être connecté entre le dispositif maître et le dispositif asservi de manière à transmettre des informations numériques entre ces deux dispositifs, et dans lesquels le dispositif maître produit une tension entre les deux fils du bus de manière à alimenter en énergie le dispositif asservi. L'invention se prête à une utilisation dans des micro-ordinateurs comportant des dispositifs asservis, tels que des mémoires à accès direct (RAM), destinés à enregistrer des données, et l'invention sera décrite ci-après dans le cadre de cette application particulière. Toutefois, il est bien évident que l'invention ne se limite pas une telle application.

De nombreux systèmes électroniques connus utilisent un dispositif pour commander le fonctionnement d'autres dispositifs. Un dispositif qui réalise une telle fonction est appelé "dispositif principal ou dispositif maître", alors qu'un dispositif dont le fonctionnement est commandé par les instructions engendrées par un dispositif maître est appelé "dispositif asservi". Un micro-ordinateur est un exemple de système qui correspond à cette description. L'unité centrale de traitement (ou CPU) d'un microprocesseur exécute un jeu d'instructions. Une mémoire à lecture seule (ou ROM) est utilisée pour stocker un jeu d'instructions alors qu'une mémoire à accès direct (ou RAM) est utilisée pour stocker les données variables engendrées et utilisées par le CPU lors de l'exécution de ces instructions. Des bus de données, d'adresses et de commande relient le CPU à la ROM et à la RAM de manière à lui permettre de communiquer avec elles.

Lorsque le CPU désire enregistrer des données dans la RAM, il envoie une commande "écrire" à la RAM ainsi que ces données et l'adresse à laquelle elles doivent être stockées. La RAM stocke ces données à l'adresse sélectionnée. De façon semblable, lorsque le CPU désire accéder à des données stockées dans la RAM, il envoie une commande "lire" à la RAM avec l'adresse à laquelle se trouvent les données auxquelles il désire accéder. La RAM répond en plaçant les données correspondant à l'adresse sélectionnée sur le bus de données pour les mettre à disposition du CPU. Le CPU fonctionne donc comme maître et commande les fonctions "lecture/écriture" de la RAM asservie. Le fonctionnement de la RAM est synchronisé avec celui du CPU à l'aide d'un signal d'horloge qui est appliqué au bus de commande par le CPU.

Dans les systèmes connus de ce type, trois bus multifilaires distincts relient généralement le CPU et la RAM de manière à, d'une part, transmettre respectivement les informations d'adresses, de données et de commande et, d'autre part, à relier aussi bien le CPU que la RAM à une source de tension.

Toutefois, il est souvent avantageux de minimiser le matériel prévu pour assurer la transmission de données numériques entre le maître et le dispositif asservi. Certains circuits de transmission de données connus ne comportent qu'un seul bus bifilaire connecté entre un dispositif maître et un dispositif asservi. Dans un tel circuit, les deux fils du bus ne sont pas utilisés uniquement pour transmettre les données entre le dispositif maître et le dispositif asservi, mais ils fournissent également l'énergie nécessaire pour assurer le fonctionnement du dispositif asservi. Les informations numériques fournies par le dispositif maître sont utilisées pour moduler (soit en fréquence, soit en amplitude) un signal porteur qui est présent sur le bus bifilaire, et le dispositif asservi est capable d'utiliser la différence de potentiel produite entre les deux fils du bus, par ce signal modulé, aussi bien comme tension d'alimentation que comme signal de synchronisation.

Pour assurer la synchronisation avec le dispositif maître, le dispositif asservi doit comprendre une horloge locale qui doit être synchronisée avec l'horloge de référence. Ces complications supplémentaires influencent de façon désavantageuse la conception des circuits de transmission de données connus.

De plus, le fait de moduler le signal porteur avec les informations numériques limite la largeur de bande disponible pour les informations numériques qui peuvent être envoyées. En effet, selon la règle de Nyquist bien connue, la largeur de bande, ou plus précisément dans le cas présent la vitesse de transmission des bits constituant l'information numérique, est limitée à la moitié de la fréquence du signal porteur. Cette dernière limitation constitue également un problème qu'il serait avantageux d'éliminer.

Le but de la présente invention est de fournir un circuit de transmission de données qui remédie aux problèmes liés aux circuits de transmission de données connus.

A cet effet, la présente invention fournit un circuit de transmission de données comprenant au moins un dispositif asservi, un dispositif maître pour commander le fonctionnement dudit dispositif asservi, et un bus à deux fils prévu pour être connecté entre ledit dispositif maître et ledit dispositif asservi pour transmettre des informations numériques entre ceux-ci, ledit dispositif maître produisant une différence de potentiel entre lesdits deux fils de manière à alimenter en énergie ledit dispositif asservi; ledit circuit de transmission étant caractérisé en ce que ledit dispositif maître comprend des moyens de production d'impulsions pour produire des impulsions dans ladite différence de potentiel, lesdites impulsions ayant une amplitude représentative desdites informations numériques, et ledit dispositif asservi comprenant des moyens de décodage desdites impulsions pour détecter lesdites impulsions et pour produire un signal de synchronisation lors de la détection de chacune desdites impulsions.

Ainsi, on fournit un circuit de transmission de données, entre ledit dispositif maître et ledit dispositif asservi, qui transmet les informations, l'énergie et les signaux de synchronisation sur deux lignes uniquement, sans nécessiter une horloge locale dans le dispositif asservi. De plus, la largeur de bande nécessaire du circuit est proche de celle qui correspond à la vitesse de transmission des bits constituant l'information numérique transmise entre le dispositif maître et le dispositif asservi.

Selon un mode de réalisation de l'invention, les moyens de production d'impulsions comprennent des moyens pour produire soit une impulsion de données d'un premier type dont l'amplitude est inférieure à une première valeur prédéterminée, soit une impulsion de données d'un deuxième type dont l'amplitude est plus grande que celle de ladite valeur prédéterminée, ladite impulsion de données d'un premier type se trouvant soit dans un état logique haut, soit dans un état logique bas, et ladite impulsion de données d'un deuxième type se trouvant dans l'autre état logique. Le dispositif maître peut de plus comporter des moyens de commande d'impulsions prévus pour faire produire par les moyens de production d'impulsions une série d'impulsions de données qui sont toutes dans le même état logique pendant l'opération de lecture des informations numériques dans le dispositif asservi, et le dispositif asservi peut comprendre des moyens pour changer l'état de certaines impulsions sélectionnées comprises dans ladite série d'impulsions de données en réponse aux informations numériques à lire.

Le dispositif maître peut ainsi lire des données contenues dans le dispositif asservi, par exemple, en produisant sur le bus de données des impulsions de niveau logique bas dont certaines sont changées en impulsions de niveau logique haut par le dispositif asservi.

La description qui suit présente en plus de détail les différentes caractéristiques du circuit de transmission de données selon la présente invention. Pour faciliter la compréhension de la présente invention, on se référera aux dessins annexés qui représentent le mode préféré de réalisation du circuit de transmission de données selon la présente invention. Le circuit de transmission de données de la présente invention ne se limite pas à ce mode préféré de réalisation.

Sur les dessins :
- la figure 1 est un schéma du circuit de transmission de données selon la présente invention;
- la figure 2 est un diagramme schématique d'un protocole de transmission prévu pour être utilisé dans le circuit de transmission de données de la figure 1;
- la figure 3 est un schéma des moyens de décodage d'impulsions du circuit de transmission de données de la figure 1;
- la figure 4 est une représentation en fonction du temps des impulsions Clk, de données et RAZ produites par les moyens de décodage des impulsions de la figure 3;
- la figure 5 est un schéma du dispositif maître et de l'un des dispositifs asservis du circuit de transmission de données de la figure 1; et,
- la figure 6 est une représentation de la forme des impulsions créées par les moyens de décodage d'impulsions de la figure 3.

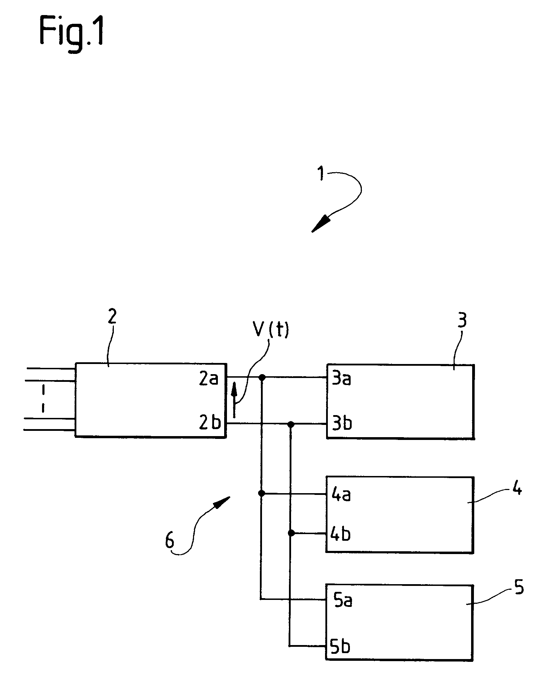

On voit sur la figure 1 un circuit de transmission de données 1 comportant un dispositif maître 2 et trois dispositifs asservis 3, 4 et 5. Le dispositif maître 2 comporte deux bornes de sortie 2a et 2b, alors que les dispositifs asservis 3, 4 et 5 comprennent des paires de bornes d'entrées référencées respectivement 3a et 3b, 4a et 4b et 5a et 5b. Un bus à deux fils 6 relie les bornes d'entrée de chacun des dispositifs asservis aux bornes de sortie du dispositif maître. Bien que la figure 1 représente trois dispositifs asservis, d'autres modes de réalisation de la présente invention pourraient en comprendre un nombre quelconque.

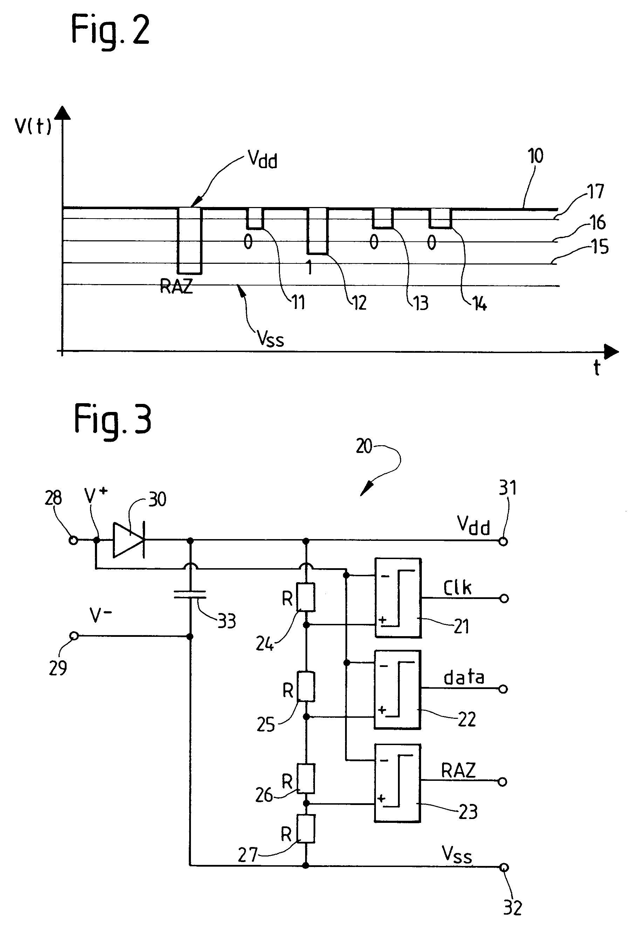

La figure 2 est un graphique de la différence de tension V(t) entre les fils du bus 6 en fonction du temps qui représente un protocole suivant lequel des informations numériques sont transmises entre le dispositif maître 2 et les dispositifs asservis 3, 4 et 5. Le tracé 10 de la tension V(t) correspond à la transmission, dans l'ordre, d'une impulsion de remise à zéro (RAZ) suivie par des impulsions numériques 11, 12, 13 et 14 représentant le code binaire 0,1,0,0. A l'état stationnaire c'est-à-dire quand aucune information n'est transmise entre le dispositif maître et l'un des dispositifs asservis, une tension V(t) égale à $(V_{dd} - V_{ss})$, où $V_{dd}$ et $V_{ss}$ sont respectivement les potentiels d'alimentation positif et négatif qui permettent aux dispositifs asservis de fonctionner, est appliquée au bus 6 par le maître 2. Les tensions $V_{dd}$ et $V_{ss}$ dépendront de la configuration particulière du circuit et de la technologie utilisée et elles peuvent avoir n'importe quelle valeur appropriée.

L'impulsion RAZ de remise à zéro et les impulsions de données 11, 12, 13 et 14 correspondent à des variations de la valeur de la tension V(t) par rapport à son niveau à l'état stationnaire. Dans le mode de réalisation représenté, ces variations ont pour effet de réduire la différence de potentiel V(t), mais dans d'autres modes de réalisation ces impulsions peuvent au contraire l'augmenter. Comme l'énergie disponible pour alimenter les dispositifs asservis est une fonction de la durée et de la période des impulsions représentées sur la figure 2, la durée de ces impulsions sera de préférence courte par rapport à celle des intervalles qui les séparent.

Un protocole à niveaux multiples est utilisé pour réaliser la communication entre le dispositif maître et les dispositifs asservis, et les informations numériques sont représentées par l'amplitude des impulsions. Selon ce protocole, un signal RAZ est transmis en plaçant sur le bus 6 une impulsion dont l'amplitude est supérieure à un niveau prédéterminé 15. De façon semblable, un signal logique "1" est transmis en plaçant sur le bus 6 une impulsion dont l'amplitude est supérieure à un niveau prédéterminé 16 mais inférieure au niveau prédéterminé 15. Un signal logique "0" est transmis en plaçant sur le bus 6 une impulsion dont l'amplitude est inférieure au niveau prédéterminé 16 mais supérieure à un autre niveau prédéterminé 17.

On comprendra que dans d'autres modes de réalisation de la présente invention, les amplitudes des impulsions peuvent être représentatives d'autres données. Par exemple, une impulsion dont l'amplitude est inférieure au niveau 16 pourrait représenter un signal logique "1" alors qu'une impulsion dont l'amplitude est supérieure au niveau 16 pourrait représenter un signal "0".

La synchronisation entre le dispositif maître et les dispositifs asservis est assurée par la détection de chacune des impulsions placées sur le bus 6 par le dispositif maître 2. Chaque dispositif asservi surveille la tension entre ses deux bornes d'entrée de manière à pouvoir détecter l'abaissement de la tension V(t) en dessous de la différence entre les potentiels 17 et $V_{ss}$. Lorsque le dispositif maître place sur le bus 6 une impulsion RAZ, une impulsion correspondant à un "1" logique et une impulsion correspondant à un "0" logique, chaque dispositif asservi détecte la présence d'une impulsion et peut utiliser celle-ci comme signal d'horloge.

La figure 3 représente un exemple d'un circuit qui peut être utilisé par chacun des dispositifs asservis pour décoder les informations numériques transmises sous forme d'impulsions par le bus 6. Le décodeur d'impulsions 20 comprend essentiellement trois comparateurs 21, 22 et 23 et quatre résistances 24, 25, 26 et 27. Chacun des comparateurs comprend une entrée inverseuse et une entrée non inverseuse, et fournit un signal de sortie de niveau logique haut lorsque la différence entre le niveau de ces deux entrées descend au-dessous d'une tension prédéterminée. Le décodeur d'impulsions 20 comporte deux bornes 28 et 29 qui sont reliées respectivement à la borne de sortie "positive" 2a et la borne de sortie "négative" 2b du dispositif maître 2. Les potentiels de référence V + et V- indiquent les potentiels instantanés auxquels se trouvent respectivement les bornes 2a et 2b. La borne 28 est reliée par l'intermédiaire d'une diode de protection 30 à une borne 31 qui fournit la tension $V_{dd}$ pour alimenter chacun des dispositifs asservis. La borne 29 est reliée à une borne 32 qui fournit la tension $V_{ss}$ aux dispositifs asservis. La borne 29 est reliée à l'entrée non conductrice de la diode 30 par l'intermédiaire d'un condensateur 33 de manière à maintenir la différence de potentiel V-(t) à la valeur ou proche de la valeur $V_{dd} - V_{ss}$, même lorsque des impulsions comme celles référencées 11 à 14 sur la figure 2 se trouvent sur le bus 6.

La borne 28 est reliée à l'entrée inverseuse de chacun des comparateurs, les résistances 24, 25, 26 et 27 ont la même valeur R et sont branchées en série entre les bornes 31 et 32 de façon à constituer un diviseur de tension. Chacune des liaisons entre deux résistances adjacentes du diviseur de tension est reliée à l'entrée non inverseuse de l'un des comparateurs. De cette façon, les comparateurs 21, 22 et 23 comparent la tension V + fournie à leur entrée inverseuses respectivement aux tensions $^3/_4$ ($V_{dd} - V_{ss}$) + $V_{ss}$, $^1/_2$ ($V_{dd}$ + $V_{ss}$) et $^1/_4$ ($V_{dd} - V_{ss}$) + $V_{ss}$.

On supposera par exemple, que lorsqu'aucune information numérique n'est transmise entre le dispositif maître et le dispositif asservi, les tensions V + et $V_{dd}$ sont toutes deux égales à 5 volts, que Vss est égal à 1 volt et que les niveaux de tension 17, 16 et 15 sont respectivement égaux à 4,3 et 2 volts. Dans ces conditions d'état stationnaire, les comparateurs 21, 22 et 23 fournissent chacun un signal de sortie de niveau logique bas.

On supposera encore que lorsqu'une impulsion RAZ est placée sur le bus, elle provoque l'abaissement de la tension V + à 1,5 volt. De façon semblable, on supposera que le placement d'une impulsion de données représentant un zéro logique sur le bus produit l'abaissement de la tension V + à 3,5 volts, et que le placement d'une impulsion représentant un "1" logique sur le bus produit un abaissement de la tension V + à 2,5 volts.

Ainsi, lorsqu'une impulsion de données représentant un zéro logique est présente sur le bus 6, les différences de potentiel entre les bornes d'entrée des comparateurs 21, 22 et 23 sont respectivement 0,5 volt, -0,5 volt et - 1,5 volts. De façon semblable, lorsqu'une impulsion représentant un "1" logique est présente sur le bus 6, les différences de potentiel entre les bornes d'entrée des comparateurs 21, 22 et 23 deviennent respectivement 1,5 volts, 0,5 volt et -0,5 volt. Enfin, lorsqu'un signal RAZ est présent sur le bus 6, la différence de potentiel entre les bornes d'entrée des comparateurs 21, 22 et 23 passent respectivement à 2,5 volts, 1,5 volts et 0,5 volts.

Chaque comparateur fournit un signal de sortie de niveau logique haut lorsque la différence de potentiel entre ses bornes d'entrée descend en dessous d'un seuil présélectionné. Dans l'exemple ci-dessus, une valeur de seuil de 0 volt peut être choisie pour chaque comparateur. On comprendra à partir de ce qui vient d'être dit que l'utilisation d'une telle valeur de seuil entraîne la production d'une impulsion "Clk" par le comparateur 21 chaque fois qu'une impulsion RAZ, une impulsion correspondant à un "1" logique ou une impulsion correspondant à un "0" logique est placée sur le bus. De façon semblable, la sortie du comparateur 22 passe à son niveau logique haut et fournit une impulsion de données chaque fois qu'un "1" logique est placé sur le bus alors que la sortie du comparateur 23 ne passe dans son état logique haut que lorsqu'une impulsion RAZ est placée sur le bus.

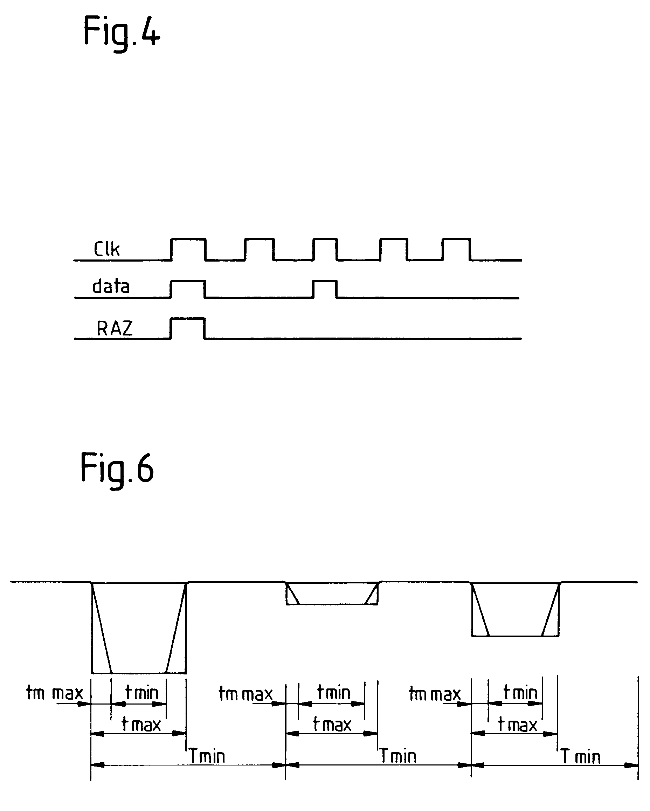

Les impulsions Clk, de données et remise à zéro produites par le décodeur d'impulsions 20 selon la courbe de la figure 2, sont représentées à la figure 4. Les impulsions Clk permettent donc la synchronisation du fonctionnement du dispositif maître et des dispositifs asservis, alors que les impulsions de données peuvent être utilisées par le concepteur du système pour transmettre soit une adresse, soit des bits de données ou de commande pour demander au dispositif asservi d'exécuter une opération désirée. De plus, les impulsions RAZ peuvent être utilisées par le dispositif maître pour remettre à zéro les dispositifs asservis.

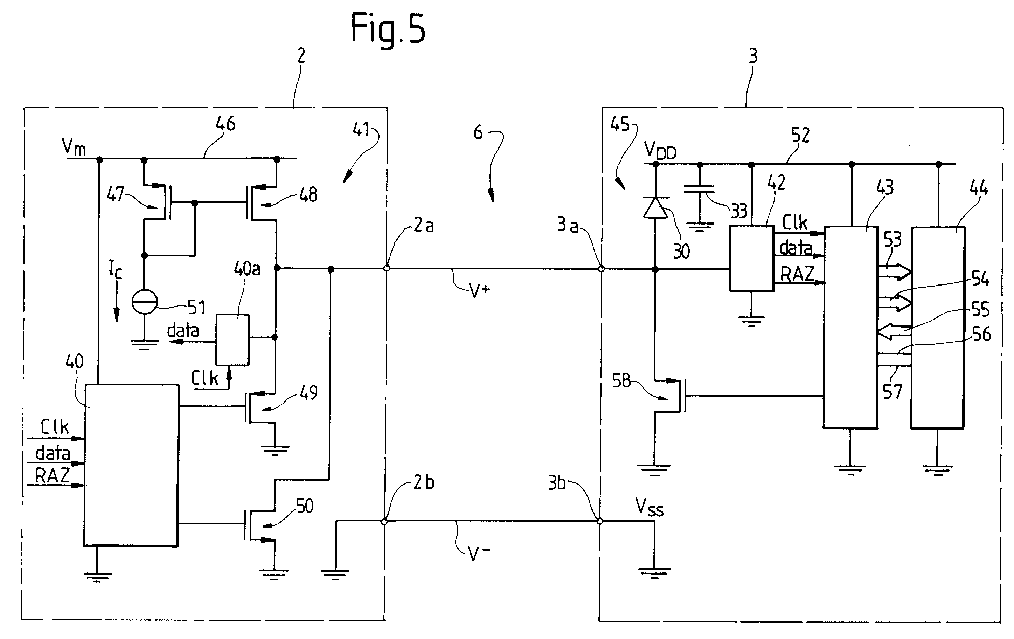

En se référant maintenant à la figure 5, on voit le dispositif maître 2, le dispositif asservi 3 et le bus 6 de la figure 1. Le dispositif maître 2 comprend des moyens de commande d'impulsions 40, des moyens de production d'impulsions 41 et des moyens de décodage 40a de l'information reçue du dispositif asservi. Le dispositif asservi 3 comprend un décodeur d'impulsions 42, des moyens de commande du dispositif asservi 43, une RAM 44 et des moyens de changement d'état des impulsions 45. Le dispositif maître 2 comprend également un pôle positif 46 pour fournir la tension $V_m$ aux moyens de commande d'impulsions 40 et aux moyens de production d'impulsions 41.

Les moyens de production d'impulsions 41 comprennent essentiellement trois MOSFETs à canal P et un MOSFET à canal N, référencés respectivement 47, 48, 49 et 50 et une source de courant 51. Les MOSFETs 47 et 48 et la source de courant 51 sont reliés ensemble, entre la borne d'alimentation positive 46 et la masse, dans une configuration de miroir de courant. Le courant qui circule de la source vers le drain du MOSFET 48 est ainsi constant et proportionnel au courant Ic produit par la source de courant 51, même en cas de changement de la tension entre sa source et son drain. Le drain du MOSFET 48 est relié à la source du MOSFET 49 et au drain du MOSFET 50. Les grilles des MOSFETs 49 et 50 sont toutes reliées aux moyens de commande d'impulsions 40 alors que le drain du MOSFET 49 et la source du MOSFET 50 sont reliés à la masse. Le drain du MOSFET 48 est relié à un premier fil du bus 6 par l'intermédiaire de la borne 2a. Le deuxième fil du bus 6 est relié à la masse du dispositif maître 2.

Une ligne d'alimentation positive 52 du dispositif asservi 3 est reliée au premier fil du bus 6 par l'intermédiaire de la diode 30 et de la borne 3a. La ligne 52 fournit de l'énergie au décodeur d'impulsions 42, aux moyens de commande 43 du dispositif asservi et à la RAM 44. Conformément à ce qui a été expliqué plus haut, le condensateur 33 est branché entre la borne 52 et la masse de manière à maintenir la tension fournie au dispositif asservi 3 à une valeur égale ou proche du niveau constant de la différence de potentiel $V_{dd}$ - $V_{ss}$. Le décodeur d'impulsions 42 est relié aux moyens de commande 43 du dispositif asservi par ses bornes de sortie pour les signaux Clk, de données et RAZ, conformément à ce qui est représenté à la figure 3. Les moyens de commande du dispositif asservi 43 sont reliés à la RAM 44 par un bus d'adresses 53, un bus 54 pour écrire des données dans la RAM 44, un bus 55 pour lire des données dans la RAM 44, une liaison d'autorisation de lecture 56 et une liaison d'autorisation d'écriture 57.

On remarquera également que dans ce mode de réalisation, les bornes 2b et 3b sont toutes deux reliées à la masse et qu'en conséquence les tensions V- et $V_{ss}$ sont toutes deux égales à 0 volt.

Les moyens 45 de changement d'état des impulsions comprennent essentiellement un MOSFET 58 à canal P dont la source est reliée à la borne 3a, le drain à la masse, et la grille aux moyens de commande 43 du dispositif asservi.

Dans les conditions stationnaires, lorsqu'aucune donnée n'est transmise entre le dispositif maître 2 et le dispositif asservi 3, les moyens de commande d'impulsions 40 fournissent une tension négative à la grille du MOSFET 49, ce qui a pour effet de rendre conducteur ce transistor. Dans ces conditions, les tensions fournies aux grilles des MOSFETs 50 et 58 sont telles que ces transistors sont rendus non conducteurs. Le courant constant qui circule de la source au drain du MOSFET 48 circule donc à travers le MOSFET 49. En contrôlant la tension grille-source du MOSFET 49, il est possible d'ajuster à une valeur désirée la tension existant entre le drain et la source de ce transistor et, par suite, la tension entre les deux fils du bus 6. Par exemple, des moyens de commande d'impulsions 40 peuvent fournir une tension négative à la grille du MOSFET 49 de telle sorte qu'une tension V + de 4 volts soit fournie par la borne 2a. Une tension $V_{dd}$ de 4 volts est fournie également pour alimenter le dispositif asservi 3.

Lorsque le dispositif maître 2 désire transmettre des données au dispositif asservi 3, les tensions appliquées aux grilles de chacun des transistors MOSFETs 49 et 50 sont modifiées. Si un "0" logique doit être transmis, la tension appliquée à la grille du MOSFET 49 est abaissée suffisamment, durant la durée d'une impulsion, pour que la tension entre sa source et son drain soit abaissée entre les niveaux 17 et 16 de la figure 2. Lorsqu'un "1" logique doit être transmis, la tension fournie est abaissée davantage, durant la durée d'une impulsion, de manière à ce que la tension source-drain descende à une valeur comprise entre les niveaux 16 et 15 de la figure 2.

Lorsqu'une impulsion RAZ doit être transmise, une impulsion de tension négative est fournie à la grille du MOSFET 50, rendant celui-ci conducteur pour la durée de l'impulsion. L'amplitude de l'impulsion est telle qu'elle provoque l'abaissement de la tension entre le drain et la source du MOSFET 50 au-dessous du niveau 15 de la figure 2. Dans ce cas, c'est le MOSFET 50 et non pas le MOSFET 49 qui contrôle la tension V + sur la borne 2a du dispositif maître 2.

Les impulsions de "0" logique, de "1" logique et RAZ produites dans la différence de potentiel entre les fils du bus 6, sont reçues et décodées par les moyens décodeurs d'impulsions 42, conformément à ce qui a été expliqué en relation avec la figure 3. Les signaux Clk, de données et RAZ fournis par les moyens décodeurs d'impulsions 43 sont appliqués aux moyens de commande des dispositifs asservis 43 pour commander le fonctionnement de la RAM 44. Les moyens de commande du dispositif asservi 43 peuvent comporter des éléments comme des registres à décalage, des portes logiques et des bascules de type D pour stocker et interpréter des signaux de données émis par des moyens décodeur d'impulsions et pour accomplir des opérations de lecture/écriture depuis et vers la RAM 44 par l'intermédiaire des bus 53, 54 et 55.

Quand le dispositif maître 2 désire lire des données dans le dispositif asservi 3, il envoie tout d'abord une série d'impulsions correspondant à des "1" logiques et à des "0" logiques au dispositif asservi 3, ce qui sera interprété comme une commande de lire les données contenues à une adresse donnée dans la RAM 44. Les moyens de commande 43 du dispositif asservi trouvent et stockent ensuite les données à envoyer dans un registre à décalage ou un autre dispositif de stockage interne.

Le dispositif maître 2 envoie ensuite une série de "0" qui sont utilisés comme horloge pour le dispositif asservi 3lorsque le dispositif asservi 3 transmet sur l'horloge fournie les données extraites de la RAM 44, les moyens de commande d'impulsions 40 contrôlent le potentiel appliqué à la base du MOSFET 49 de manière à ce qu'une série d'impulsions de niveau logique bas soient engendrées dans la tension existant entre les deux lignes du bus 6. Si les bits de données à transmettre au dispositif maître 2 sont des "0" logiques, le dispositif asservi ne modifie pas les impulsions.

Les moyens de décodage 40a permettent la lecture de l'information émise par le dispositif asservi 3. Ces moyens peuvent être constitués d'un circuit comparateur qui compare le niveau de tension reçu à une valeur de seuil donné.

Toutefois, si un bit de données à transmettre est un "1" logique, les moyens de commande du dispositif asservi 3 fournissent une impulsion de tension négative à la base du MOSFET 58 de manière à ce que la chute de tension entre son drain et sa source s'abaissent jusqu'à un niveau situé entre les niveaux 16 et 15 de la figure 2 pour la durée d'une impulsion. Le dispositif asservi 3 transforme ainsi une impulsion de niveau logique bas en une impulsion de niveau logique haut chaque fois qu'un bit de données à lire par le dispositif maître est un "1" logique.

On peut se rendre compte que lorsque les données fournies par le dispositif asservi 3 sont lues par le dispositif maître 2, l'impédance entre les deux fils du bus 6 et la tension V + sont commandées par le courant circulant dans le MOSFET 48 et dans celui des deux MOSFETs 49 et 50, dont la tension de grille est la plus basse. Dans la disposition particulière de la figure 5, l'impédance du bus 6 est commandée par l'utilisation d'impédances non linéaires (les MOSFETs 49, 50 et 58). Toutefois, dans d'autres modes de réalisation de la présente invention des impédances linéaires telles que des résistances fixes et/ou variables peuvent être utilisées. Les moyens de commande 43 du dispositif asservi, par exemple, pourraient relier sélectivement de telles résistances à la borne 3a du dispositif asservi 3 de manière à changer l'impédance du bus et donc à changer l'état d'impulsions de données sélectionnées qui ont été placées sur le bus 6 par le dispositif maître 2.

L'homme du métier comprendra que les impulsions réelles Clk, de données et RAZ produites par les moyens de décodage 20 n'auront pas la forme représentée à la figure 4, mais qu'elles auront plutôt un temps de montée et un temps de descente mesurable. La figure 6 représente de façon schématique le temps de montée maximum $tm_{max}$ et la durée minimum $t_{min}$ d'impulsions produites par les moyens de décodage d'impulsions 20. Puisque les impulsions produites par les moyens de décodage d'impulsions 20 commencent toutes à être produites au même instant, des erreurs peuvent apparaître si un dispositif asservi lit les impulsions de données et les impulsions RAZ sur le flanc montant des impulsions Clk. Pour permettre à un dispositif asservi de lire les impulsions de données et RAZ produites par les moyens de décodage d'impulsions 20 sans parasites, les impulsions Clk peuvent être retardées d'un temps plus long que $tm_{max}$ et plus court que la somme de $tm_{max} + t_{min}$.

La figure 6 représente également de façon schématique la durée maximum d'une impulsion $t_{max}$ et la période minimum d'une impulsion $T_{min}$. L'énergie disponible pour alimenter les dispositifs asservis est fonction non seulement de l'amplitude des impulsions sur le bus 6 mais également de la relation entre $t_{max}$ et $T_{min}$. Un concepteur de système pourra en conséquence choisir de spécifier $t_{max}$ et $T_{min}$, selon les besoins en énergie des dispositifs asservis utilisés dans une application particulière. Par exemple, les impulsions peuvent avoir une durée $t_{min}$ qui est inférieure à la moitié de leur période $T_{min}$.

Enfin, l'homme du métier comprendra que diverses modifications et/ou additions peuvent être apportées au circuit de transmission de données sans sortir du cadre de la présente invention telle que définie par les revendications annexées.

**Revendications**

1. Circuit de transmission de données comprenant
   - au moins un dispositif asservi (3),
   - un dispositif maître (2) pour commander le fonctionnement dudit dispositif asservi (3), et
   - un bus à deux fils (6) prévu pour être connecté entre ledit dispositif maître (2) et ledit dispositif asservi (3) pour transmettre des informations numériques entre ceux-ci,

   ledit dispositif maître (2) produisant une différence de potentiel (V(t)) entre lesdits deux fils de manière à fournir de l'énergie audit dispositif asservi (3), ledit dispositif maître (2) comprenant des moyens (41) de production d'impulsions pour produire des impulsions dans ladite différence de potentiel (V(t)), lesdits moyens de production d'impulsions (41) comprennent des moyens (49) pour produire une première impulsion de données dont l'amplitude est inférieure à une première valeur prédéterminée (16), et pour produire une seconde impulsion de données dont l'amplitude est supérieure à ladite première valeur prédéterminée (16), ladite première impulsion de données étant soit dans un état logique haut, soit dans un état logique bas et ladite seconde impulsion de données étant dans l'autre état logique, ledit dispositif asservi (3) comprenant des moyens (20) de décodage des impulsions pour détecter lesdites impulsions et pour produire un signal de synchronisation (Clk) lors de la détection de chacune desdites impulsions, caractérisé en ce que ledit dispositif maître (2) comprend encore des moyens de commande d'impulsions (40) pour faire produire par lesdits moyens de production d'impulsions une série desdites impulsions de données ayant toutes le même état logique, lorsque lesdites informations numériques sont lues à partir dudit dispositif asservi (3),
   et en ce que ledit dispositif asservi (3) comprend des moyens (43, 58) pour changer l'état de certaines desdites impulsions de données dans ladite série en réponse aux informations numériques à lire.

2. Circuit de transmission de données selon la revendication 1, caractérisé en ce que lesdits moyens de changement d'état (43, 58) comprennent des moyens (58) pour changer l'impédance entre les deux lignes dudit bus (6) pendant la durée des impulsions sélectionnées.

3. Circuit de transmission de données selon l'une quelconque des revendications précédentes, caractérisé en ce que lesdits moyens de production d'impulsions (41) comprennent en outre des moyens (50) pour produire une impulsion de remise à zéro RAZ dont l'amplitude est plus grande qu'une deuxième valeur prédéterminée (15).

4. Circuit de transmission de données selon la revendication 3, caractérisé en ce que ladite seconde valeur prédéterminée (15) est plus grande que ladite première valeur prédéterminée (16).

5. Circuit de transmission de données selon l'une quelconque des revendications précédentes, caractérisé en ce que lesdits moyens de décodage d'impulsions (42) comprennent des moyens (22, 24, 25, 26, 27) pour produire un signal d'information (donnée) se trouvant soit dans un état logique bas, soit dans un état logique haut au moment de la détection de l'une quelconque desdites impulsions ayant une amplitude inférieure à ladite première valeur (16), et se trouvant dans l'autre état logique en cas de détection d'une impulsion ayant une amplitude plus grande que ladite première valeur 16.

6. Circuit de transmission de données selon la revendication 5, caractérisé en ce que lesdits moyens de décodage d'impulsions (42) comprennent en outre des moyens (23, 24, 25, 26, 27) pour produire un signal de remise à zéro (RAZ) en cas de détection d'une quelconque desdites impulsions ayant une amplitude plus grande que ladite deuxième valeur (15).

7. Circuit de transmission de données selon l'une quelconque des revendications précédentes, caractérisé en ce que chacune desdites impulsions correspond à une réduction de ladite différence de potentiel (V(t)).

# Fig.1

## Fig. 2

## Fig. 3

# Fig.4

Clk

data

RAZ

# Fig.6

tm max | t min
t max
Tmin

tm max | t min
t max
Tmin

tm max | t min
t max
T min

Fig.5

Office européen
des brevets

**RAPPORT DE RECHERCHE EUROPEENNE**

Numero de la demande

EP 94 10 9474

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| X | INTERNATIONAL JOURNAL OF ELECTRONICS vol. 67, no. 5, Novembre 1989, LONDON GB pages 809 - 817 XP87244 A.D. SINGH 'Precharged CMOS quaternary logic encoder-decoder circuits.' | 1,5 | G06F13/40 H03M5/20 |
| A | * page 809, alinéa 3 - page 810, alinéa 2 * <br> * page 812 - page 815 * <br> * abrégé * <br> --- | 2-4,6,7 | |
| X | US-A-4 661 801 (CHEN ET AL.) <br> * colonne 3, ligne 31 - colonne 7, ligne 3 * <br> * abrégé; revendications 1-3; figure 1 * <br> --- | 1 | |
| A | EP-A-0 110 179 (INTERNATIONAL BUSINESS MACHINES CORPORATION) <br> * page 7, ligne 5 - ligne 27 * <br> * page 8, ligne 6 - page 11, ligne 22 * <br> * abrégé; figure 1 * <br> ----- | 1-7 | DOMAINES TECHNIQUES RECHERCHES (Int.Cl.5) G06F H03M |

Le présent rapport a été établi pour toutes les revendications

| Lieu de la recherche | Date d'achèvement de la recherche | Examinateur |
|---|---|---|
| LA HAYE | 5 Octobre 1994 | Nguyen Xuan Hiep, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

............................................................................
& : membre de la même famille, document correspondant

EPO FORM 1503 03.82 (P04C02)